# FASCICULE DE BREVET EUROPEEN

(11) **EP 2 724 385 B1**
(45) Date de publication et mention de la délivrance du brevet: **21.08.2019**
(21) Numéro de dépôt: 12741094.2
(22) Date de dépôt: 25.06.2012
(51) Int. Cl.: H01L 31/20, H01L 31/0747, H01L 31/18, H01L 31/024

(54) **PROCEDE DE TRAITEMENT D'UNE CELLULE PHOTOVOLTAÏQUE A HETEROJONCTION**
VERFAHREN ZUR BEHANDLUNG EINER PHOTOVOLTAISCHEN ZELLE MIT HETEROÜBERGANG
METHOD OF TREATING A HETEROJUNCTION PHOTOVOLTAIC CELL

(30) Priorité: 27.06.2011 FR 1155716
(43) Date de publication de la demande: 30.04.2014
(73) Titulaire: Commissariat à l'Énergie Atomique et aux Énergies Alternatives, 75015 Paris (FR)
(72) Inventeur: HARRISON, Samuel, 38530 Pontcharra (FR); RIBEYRON, Pierre-Jean, 38330 Saint Ismier (FR)
(74) Mandataire: Gevers & Orès
(86) Numéro de dépôt international: PCT/IB2012/053204
(87) Numéro de publication internationale: WO 2013/001440

(56) Documents cités:
- JP-A- 2007 294 830
- DE WOLF S ET AL: "Very fast light-induced degradation of a-Si:H/c-Si(100) interfaces", PHYSICAL REVIEW B, vol. 83, no. 23, 7 juin 2011 (2011-06-07), pages 233301-1-233301-4, XP055025598, American Institute of Physics, NY, USA ISSN: 1098-0121, DOI: 10.1103/PhysRevB.83.233301
- MISHIMA T ET AL: "Development status of high-efficiency HIT solar cells", SOLAR ENERGY MATERIALS AND SOLAR CELLS (19TH INTERNATIONAL PHOTOVOLTAIC SCIENCE AND ENGINEERING CONFERENCE AND EXHIBITION (PVSEC-19), 9-13 NOVEMBRE 2009, JEJU, KR), vol. 95, no. 1, janvier 2011 (2011-01), pages 18-21, XP027476522, ELSEVIER SCIENCE PUBLISHERS, AMSTERDAM, NL ISSN: 0927-0248, DOI: 10.1016/J.SOLMAT.2010.04.030 [extrait le 2010-04-28]

## Description

L'invention se rapporte à un procédé de traitement de cellules photovoltaïques pour améliorer et stabiliser leur rendement.

Les cellules photovoltaïques à hétérojonction sont constituées par l'association de deux matériaux semi-conducteurs : silicium cristallin et silicium amorphe, par opposition aux cellules à homojonction constituées en associant deux zones du même matériau.

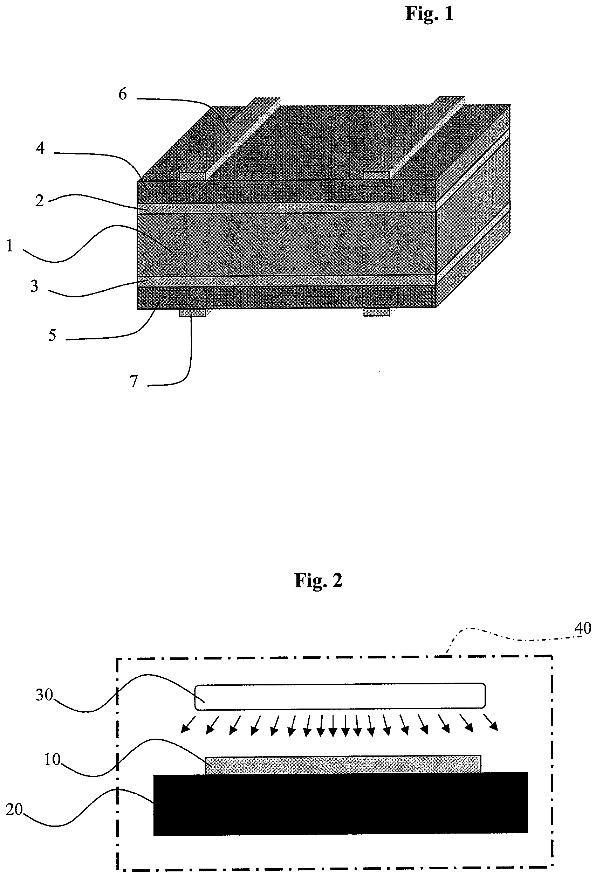

Plus particulièrement, une cellule à hétérojonction comprend, en référence à la figure 1, une couche centrale 1 en silicium cristallin sur et sous laquelle sont disposées deux couches 2 et 3, dites « de passivation » en silicium amorphe, c'est-à-dire une couche supérieure 2 et une couche inférieure 3.

Le substrat silicium utilisé en couche centrale 1 est un substrat de type mono-cristallin (CZ ou FZ), de type N, c'est-à-dire en particulier dépourvu d'atomes de Bore dans le volume, sauf à l'état de traces (l'état de trace est défini, dans la présente invention, comme une concentration de Bore, notée [B], comprise entre 0 et 1.10¹⁶at/cm³).

Dans le cadre de l'invention, les couches de passivation 2 et 3 sont en silicium amorphe hydrogéné (a-Si :H).

Le substrat en silicium cristallin 1 doit contenir le moins d'impuretés possibles pour maximiser les performances de la cellule photovoltaïque. De la même manière, l'interface entre le silicium cristallin 1 et les couches 2 et 3 en silicium amorphe a-Si :H doit être la plus parfaitement nettoyée et passivée possible avant dépôt afin de garantir une très bonne tension aux bornes de la cellule. Ces nettoyages ont pour objectif d'éliminer les particules organiques et métalliques, mais aussi de saturer en hydrogène tous les défauts de surface résiduels en surface. Un certain nombre de nettoyages différents existent, plus ou moins efficaces pour améliorer la passivation. De la même manière, la passivation peut être améliorée en jouant sur la nature de la couche de silicium amorphe 2-3, son épaisseur et son dopage.

Chaque couche de silicium amorphe 2-3 est recouverte d'une couche, respectivement supérieure 4 et inférieure 5, d'un oxyde transparent conducteur électrique.

Des électrodes métalliques 6 sont disposées sur la face libre de la couche 4 d'oxyde transparent conducteur électrique, dite « face avant » car destinée à recevoir le flux lumineux en utilisation, et des électrodes métalliques 7 sont disposées sur la face libre de la couche 5 d'oxyde transparent conducteur électrique, dite « face arrière », par opposition à la face avant.

Les électrodes 6 sont constituées d'une grille métallique, afin de laisser passer les photons vers les couches de silicium 1, 2 et 3.

Les électrodes 7 peuvent être soit une grille (comme les électrodes 6), soit une couche continue. Dans ce cas, les photons ne peuvent pas passer à travers cette couche opaque pour rejoindre les couches de silicium 1, 2 et 3.

L'article de De Wolf et al. (Physical Review B, vol. 83, no. 23, 7 juin 2011, pages 233301-1 - 233301-4, XP55025598) étudie l'influence de la dégradation induite par le rayonnement lumineux (LID) sur une surface en silicium cristallin passivée par un silicium amorphe hydrogéné. Le but de cette étude est d'analyser la nature et la stabilité des défauts volumiques et d'interface du silicium amorphe par le biais du paramètre τeff (durée de vie des porteurs de charge) qui détermine seulement la qualité de la passivation. Cet article ne propose pas d'amélioration, ni même de stabilisation des performances (en particulier du rendement) d'une cellule photovoltaïque à hétérojonction. Au contraire, cet article montre (figure 1b), que l'évolution de ce coefficient en fonction du temps sous illumination n'est pas très bonne pour le a-Si :H/c-Si(111) et pour le a-Si :H/c-Si(100), puisqu'après une légère amélioration, il décline au bout de 6 heures.

Afin d'améliorer le rendement d'une cellule photovoltaïque, il a déjà été proposé de soumettre la cellule à un traitement thermique (chauffage ce la cellule à une température comprise entre 50°C et 230°C) pendant une mise sous tension de la cellule. Ce type de traitement a toujours été réservé aux cellules constituées de silicium enrichi en atome de Bore. En effet, de telles cellules peuvent avoir un rendement de conversion énergétique qui diminue au cours de leur utilisation (c'est-à-dire lorsqu'elles sont éclairées). Cet effet est lié à la formation, lors de l'éclairement, de complexes qui associent un atome de bore en position substitutionnelle (Bₛ) et un dimère d'oxygène (Oᵢ₂). Lors de l'éclairement, le dimère mobile d'oxygène diffuse vers l'atome de bore immobile. Le complexe formé introduit un niveau en énergie profond dans la bande interdite du silicium, qui permet la recombinaison des charges libres, et par conséquent diminue la durée de vie des porteurs de charges et le rendement de conversion énergétique de la cellule.

Le document de brevet JP 2007 294830 A (référencé D3 ci-après) concerne un procédé de traitement de cellules photovoltaïques à hétérojonction de type n comprenant un couche centrale en silicium cristallin et sous laquelle sont disposées des couches de passivation en silicium amorphe hydrogéné. D3 décrit une étape de chauffage de la cellule photovoltaïque à haute température, comprise entre 190°C et 390°C pendant une durée d'illumination par un flux lumineux pendant une durée très courte inférieure à 60 secondes.

Pour une cellule à hétérojonction de type N (c'est-à-dire dont le substrat de silicium utilisé pour la couche centrale 1 est dépourvu de Bore, sauf à l'état de trace), la Demanderesse s'est aperçu qu'un tel traitement pouvait être adapté pour améliorer le rendement de cette cellule, alors même que cette cellule ne contient pas de Bore, sauf à l'état de trace.

L'invention a donc pour objet de proposer un procédé de traitement de cellules photovoltaïques de type N dépourvu de Bore.

A cette fin, l'invention propose un procédé selon la revendication 1.

D'autres modes de réalisation sont définis dans les revendications dépendantes 2 - 6.

D'autres caractéristiques de l'invention seront énoncées dans la description détaillée ci-après, faite en référence aux figures annexées qui représentent, respectivement :
- la figure 1, une vue schématique en perspective d'une cellule à hétérojonction utilisée dans le cadre de l'invention ;
- la figure 2, une vue schématique en coupe d'une installation pour mettre en oeuvre le procédé selon l'invention ;
- la figure 3, un graphique illustrant le gain en passivation d'une cellule à hétérojonction subissant un traitement selon l'invention ; et
- la figure 4, un graphique illustrant l'impact de l'intensité du flux d'illumination incident sur le gain final en passivation d'une cellule à hétérojonction, pour des intensités du flux entre 3.5 et 5A.

Le procédé de traitement de cellules photovoltaïques selon l'invention comprend une première étape de fourniture d'une cellule photovoltaïque à hétérojonction de type N, c'est-à-dire dépourvue d'atomes de Bore, sauf à l'état de traces (concentration de Bore, notée [B], comprise entre 0 et 1.10¹⁶at/cm³). La cellule comprenant une couche centrale 1 en silicium cristallin sur et sous laquelle sont disposées deux couches 2 et 3 de passivation en silicium amorphe hydrogéné.

Avantageusement, au moins une des couches en silicium amorphe 2 et/ou 3 est dopée ou micro-dopée. La couche 2 peut être plus particulièrement dopée (ou micro-dopée) par un dopage de type P et la couche 3 peut être dopée (ou micro-dopée) par un dopage de type N. Dans un cas particulier, la couche 3 peut être intrinsèque, c'est-à-dire non dopée (un semi-conducteur intrinsèque est un matériau semi-conducteur dont le comportement électrique ne dépend que de sa structure, et non de l'adjonction d'impuretés comme dans le cas du dopage. Dans un semi-conducteur intrinsèque, les porteurs de charge ne sont créés que par des défauts cristallins et par excitation thermique. Le nombre d'électrons dans la bande de conduction est égal au nombre de trous dans la bande de valence).

De préférence, les couches en silicium amorphe 2 et/ou 3 ont une épaisseur inférieure ou égale à 35nm. Dans le cas de couches 2 et/ou 3 en silicium amorphe dopé (ou micro-dopé), l'épaisseur est avantageusement comprise entre 15 et 20nm. Dans le cas d'une couche 3 en a-Si intrinsèque, l'épaisseur est avantageusement inférieure ou égale à 10nm.

Ensuite, la cellule est chauffée pendant une durée de traitement déterminée, tout en soumettant la cellule photovoltaïque à un flux lumineux déterminé.

La température de l'étape de chauffage sous illumination est comprise entre 55°C et 80°C.

Cette étape de chauffage sous illumination réalisée au cours du procédé de traitement des cellules photovoltaïques de type N n'est pas précédée par une étape de recuit (par exemple à une température de 220°C) pendant une durée importante. La seule étape de recuit susceptible d'être réalisée à une température de l'ordre de 200°C est celle réalisée pour fabriquer les métallisations de la cellule.

Le traitement peut se faire à l'air libre ou dans une enceinte chauffante, telle qu'un four. Il est inutile d'effectuer le traitement dans une enceinte à pression, atmosphère ou hydrométrie contrôlée.

Un schéma simplifié du dispositif utilisé est présenté en figure 2. La cellule considérée 10 est déposée sur une plaque chauffante 20 et sous une source lumineuse 30.

Il est possible de travailler avec une ou plusieurs source(s) lumineuse(s).

En outre, la plaque chauffante 20 peut être remplacée par un four 40 à la température désirée.

Ainsi, l'invention décrite se propose d'améliorer encore plus la passivation de surface pour un couple couche active déposée/nettoyage donné, et ce sans jouer sur les procédés de nettoyage ou sur la nature des couches déjà largement connues. L'illumination sous température se fait après les étapes de nettoyage et de dépôt des couches passivantes 2 et 3. Elle peut d'ailleurs ensuite se faire indifféremment en cours de fabrication de la cellule (couches 4 - 5 et/ou électrodes 6 - 7 non déposées), ou sur une cellule terminée (couches 4 - 5 et électrodes 6 - 7 déposées).

Dans le cas où le procédé selon l'invention est utilisé sur une cellule terminée, pour une cellule à hétérojonction classique avec grille de métallisation en face avant et en face arrière, le flux lumineux peut être appliqué indifféremment via la face avant ou la face arrière. Dans le cas où une métallisation opaque est utilisée sur la face arrière (couche continue métallique par exemple), l'éclairement doit obligatoirement être appliqué sur la face avant.

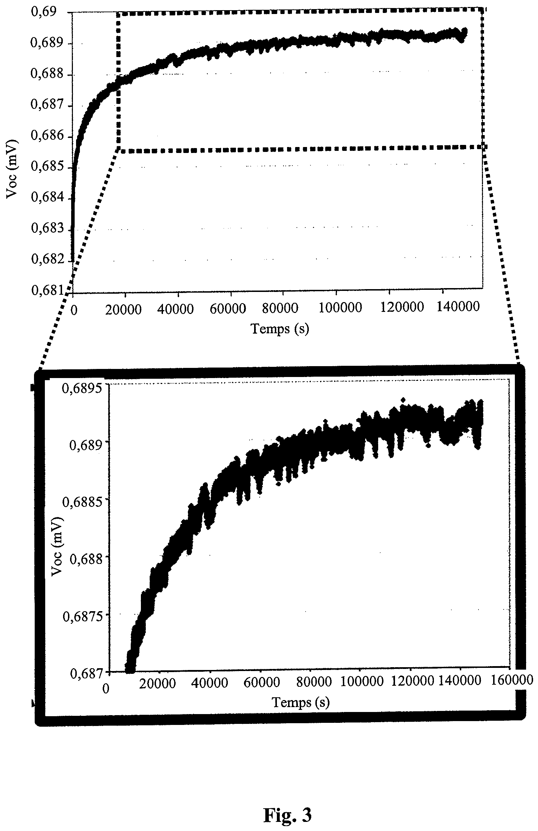

Un exemple de gain en passivation (Voc) en fonction du temps d'éclairement est présenté en figure 3. On note un gain continu en passivation qui tend à se saturer au cours du temps. Autrement dit, à éclairement et chauffage constant, il devient inutile de poursuivre le traitement au-delà d'une durée seuil.

La durée de traitement selon l'invention est comprise entre 30 minutes et 12 heures. Avantageusement, la durée de traitement est d'environ 10 heures pour un flux lumineux d'au moins 100 W/m², de préférence supérieur ou égal à 250W/m², avantageusement supérieur ou égal à 500W/m².

Pour l'illumination, il est nécessaire d'apporter une quantité suffisante d'énergie pour activer correctement le procédé.

D'une manière générale, plus l'intensité lumineuse est importante, plus l'effet sur le rendement est fort et rapide. Il est ainsi avantageux d'un point de vue industriel, d'aller vers un procédé de traitement qui présente une puissance d'illumination élevée.

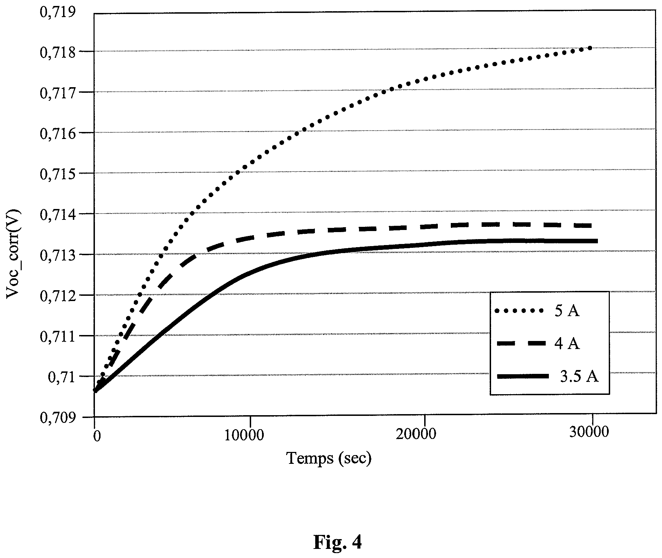

De préférence, on propose d'éclairer la cellule avec un halogène supérieur ou égal à 500W de puissance. Cependant, un gain en passivation est observé quelle que soit l'énergie de l'éclairement incident. Mais plus l'intensité de l'éclairement diminue, plus le gain en passivation sera faible et surtout, dans l'optique d'une industrialisation du procédé, plus la cinétique de la réaction sera diminuée. Ainsi, comme le montre la figure 4, la puissance de l'illumination a un effet déterminant sur l'intensité et la cinétique du gain en passivation. A températures de chauffage égales, les cellules éclairées avec une intensité de flux lumineux de 3,5 A (courbe en trait plein) et de 4 A (courbe en tirets) saturent beaucoup plus rapidement qu'une cellule éclairée avec une intensité de flux lumineux de 5 A (courbe en points), et à une valeur inférieure de passivation.

Pour déterminer la limite haute de puissance d'éclairement à appliquer en fonction des caractéristiques de la cellule à traiter, il est nécessaire de prendre en compte l'échauffement de la cellule généré par l'éclairement. En effet, les cellules à hétérojonction de type N se dégradent pour des températures supérieures ou égales à 200°C. Il faut donc veiller à ce que l'intensité du flux lumineux incident soit limitée en termes d'échauffement, car celui-ci s'ajoute à l'échauffement réalisé par la plaque chauffante ou le four.

Dans un exemple non revendiqué, la température de chauffe de la plaque ou du four est comprise entre 20 et 200°C, avantageusement entre 35 et 80°C. Cela dépend fortement du type de substrat et du type de couche de passivation utilisée.

Selon d'autres caractéristiques, la cellule photovoltaïque à hétérojonction de type N peut également être de type RCC, c'est-à-dire que toutes les métallisations et couches actives sont regroupées sur la face arrière de la cellule. La surface arrière peut alors être la seule passivée par un dépôt de couche amorphe hydrogénée. Le dépôt en face avant est donc indifférent, pourvu qu'il soit transparent au maximum à l'intensité du flux lumineux incident et qu'il assure une bonne passivation de surface.

Par ailleurs, le procédé selon l'invention est avantageusement continu, mais il peut être séquentiel, c'est-à-dire qu'il peut être interrompu puis repris.

La cellule photovoltaïque à hétérojonction de type N fournie peut comprendre une couche antiréflectrice favorisant, ainsi, la pénétration des photons dans la cellule.

## Revendications

1. Procédé pour améliorer et stabiliser le rendement de cellules photovoltaïques de type N, ledit procédé comprenant les étapes suivantes :
- fournir une cellule photovoltaïque à hétérojonction de type N, comprenant une couche centrale (1) en silicium cristallin sur et/ou sous laquelle est disposée une couche (2-3) de passivation en silicium amorphe hydrogéné, la concentration en atomes de Bore dans ladite couche centrale étant comprise entre 0 et 1 x10¹⁶ atomes/cm³;
- chauffer cette cellule à une température de chauffage pendant une durée de traitement, tout en soumettant la cellule photovoltaïque à un flux lumineux supérieur ou égal à 100 W/m²,
- ledit procédé étant **caractérisé en ce que** la durée de traitement est comprise entre 30 minutes et 12 heures et **en ce que** la température de chauffage est comprise entre 55°C et 80°C.

2. Procédé selon la revendication 1, dans lequel le flux lumineux est supérieur ou égal à 250 W/m², avantageusement supérieur ou égal à 500 W/m².

3. Procédé selon l'une quelconque des revendications 1 ou 2, dans lequel la durée de traitement est d'environ 10 heures.

4. Procédé selon l'une quelconque des revendications 1 à 3, dans lequel l'étape de chauffage sous éclairement est continue ou séquentielle.

5. Procédé selon l'une quelconque des revendications 1 à 4, dans lequel la cellule photovoltaïque à hétérojonction de type N fournie comprend des électrodes métalliques (6-7) en surface.

6. Procédé selon l'une quelconque des revendications 1 à 4, dans lequel la cellule photovoltaïque à hétérojonction de type N comprend au moins une couche antiréflectrice.

## Patentansprüche

1. Verfahren zur Verbesserung und Stabilisierung des Wirkungsgrades von Photovoltaikzellen vom Typ N, wobei das Verfahren die folgenden Schritte umfasst:
- Bereitstellen einer Heteroübergangs-Photovoltaikzelle vom Typ N, eine zentrale Schicht (1) aus kristallinem Silizium umfassend, auf und/oder unter der eine Passivierungsschicht (2-3) aus hydriertem, amorphem Silizium angeordnet ist, wobei die Konzentration an Boratomen in der zentralen Schicht zwischen 0 und 1x10¹⁶ Atome/cm³ liegt;
- Erwärmen dieser Zelle auf eine Erwärmungstemperatur während einer Behandlungsdauer, wobei die Photovoltaikzelle einem Lichtstrom größer oder gleich 100 W/m² ausgesetzt wird,
- wobei das Verfahren **dadurch gekennzeichnet ist, dass** die Behandlungsdauer zwischen 30 Minuten und 12 Stunden enthalten ist, und dass die Erwärmungstemperatur zwischen 55 °C und 80 °C enthalten ist.

2. Verfahren nach Anspruch 1, bei dem der Lichtstrom größer oder gleich 250 W/m², in vorteilhafter Weise größer oder gleich 500 W/m² ist.

3. Verfahren nach einem der Ansprüche 1 oder 2, bei dem die Behandlungsdauer etwa 10 Stunden beträgt.

4. Verfahren nach einem der Ansprüche 1 bis 3, bei dem der Schritt des Erwärmens unter Beleuchtung kontinuierlich oder sequentiell ist.

5. Verfahren nach einem der Ansprüche 1 bis 4, bei dem die bereitgestellte Heteroübergangs-Photovoltaikzelle vom Typ N Metallelektroden (6-7) an der Oberfläche umfasst.

6. Verfahren nach einem der Ansprüche 1 bis 4, bei dem die bereitgestellte Heteroübergangs-Photovoltaikzelle vom Typ N mindestens eine Antireflexschicht umfasst.

## Claims

1. Method for improving and stabilising the yield of n-type photovoltaic cells, said method comprising the following steps:
- providing an n-type heterojunction photovoltaic cell, comprising a central crystalline silicon layer (1) on and/or under which a passivation layer (2-3) made of hydrogenated amorphous silicon is deposited, with the concentration in Boron atoms in said central layer being between 0 and 1 x10¹⁶ atoms/cm³,
- heating this cell to a heating temperature during treatment duration, while still subjecting the photovoltaic cell to a light flux greater than or equal to 100 W/m²,
- said method being **characterised in that** the treatment duration is between 30 minutes and 12 hours and **in that** the heating temperature is between 55°C and 80°C.

2. Method according to claim 1, wherein the light flux is greater than or equal to 250 W/m², advantageously greater than or equal to 500 W /m².

3. Method according to any of claims 1 or 2, wherein the treatment duration is about 10 hours.

4. Method according to any of claims 1 to 3, wherein the heating step under illumination is continuous or sequential.

5. Method according to any of claims 1 to 4, wherein the n-type heterojunction photovoltaic cell supplied comprises metal electrodes (6-7) on the surface.

6. Method according to any of claims 1 to 4, wherein the n-type heterojunction photovoltaic cell comprises at least one anti-reflective layer.
